(19) Europäisches Patentamt
European Patent Office
Office européen des brevets

(11) EP 2 105 963 A2

(12) EUROPEAN PATENT APPLICATION

(43) Date of publication:
30.09.2009 Bulletin 2009/40

(51) Int Cl.:
*H01L 27/146* (2006.01)

(21) Application number: 09003889.4

(22) Date of filing: 18.03.2009

(84) Designated Contracting States:
AT BE BG CH CY CZ DE DK EE ES FI FR GB GR
HR HU IE IS IT LI LT LU LV MC MK MT NL NO PL
PT RO SE SI SK TR
Designated Extension States:
AL BA RS

(30) Priority: 25.03.2008 JP 2008078212

(71) Applicant: Kabushiki Kaisha Toshiba
Minato-ku
Tokyo (JP)

(72) Inventors:
• Honda, Hiroto
Tokyo (JP)
• Funaki, Hideyuki
Tokyo (JP)
• Fujiwara, Ikuo
Tokyo (JP)

(74) Representative: HOFFMANN EITLE
Patent- und Rechtsanwälte
Arabellastrasse 4
81925 München (DE)

(54) **Infrared detector and solid state image sensor having the same**

(57)    An infrared detector includes: a readout wiring portion provided on a semiconductor substrate; a support structure portion disposed over a concave portion formed in a surface portion of the semiconductor substrate, the support structure portion having connection wiring connected electrically to the readout wiring portion; and a cell portion disposed over the concave portion and supported by the support structure portion. The cell portion includes: an infrared absorption layer absorbing incident infrared rays; and a plurality of thermoelectric conversion elements connected electrically to the support structure portion and insulated electrically from the infrared absorption layer to generate an electric signal by detecting a temperature change of the cell portion, each of the thermoelectric conversion elements includes a semiconductor layer, a p-type silicon layer and an n-type silicon layer formed with a space between them in the semiconductor layer, and a polysilicon layer formed on the semiconductor layer between the p-type silicon layer and the n-type silicon layer.

FIG. 1

**Description**

BACKGROUND OF THE INVENTION

Field of the Invention

The present invention relates to an infrared detector and a solid state image sensor having the infrared detector.

Related Art

Infrared sensors mainly corresponding to infrared rays in the 8 to 12 $\mu$m band have high sensitivity especially to infrared rays radiated from an object having a temperature close to the room temperature. Therefore, application of the infrared sensors mainly corresponding to infrared rays in the 8 to 12 $\mu$m band to security cameras and vehicle mounted forward monitoring cameras is being started. In recent years, infrared sensors of "heat type" which sense infrared rays without cooling the device have become the main stream with development of the MEMS (Micro-Electro-Mechanical System) process.

The uncooled infrared sensor absorbs infrared rays condensed by a lens for far infrared rays (mainly a Ge lens) by using arrayed cells thermally isolated from a semiconductor substrate, conducts thermoelectric conversion on a temperature rise generated in cells, reads out the result as an electric signal, and conducts imaging.

In recent years, a silicon pn junction diode is used as the thermoelectric conversion device in some examples. This diode utilizes the fact that the forward characteristics of the pn junction change according to the temperature change. If the pixel temperature rises due to infrared ray absorption when a constant forward current is let flow through the pn junction, then the forward voltage of the pn junction decreases. Since this effect is in proportion to the number of pn junctions connected in series, for example, approximately six to ten pn junctions are formed in one cell and connected by wiring.

A technique for simplifying the wiring layer in a cell of a heat type infrared sensor by converting the silicon surface to silicide (metallizing silicon) instead of forming wiring between pn junctions of aluminum and forming a contact plug which connects the wiring to the silicon surface, so as to be able to responsive to incident infrared rays fast is disclosed in JP-A 2003-65842 (KOKAI).

According to the technique described in JP-A 2003-65842 (KOKAI), a heat type infrared sensor which can respond fast owing to a lowered thermal capacity obtained by simplifying the wiring layer is proposed. However, there is a problem that infrared rays which cannot be absorbed completely by an infrared absorption layer are transmitted by a silicon layer having no silicide formed therein which occupies a greater part of cells and consequently the sensitivity cannot be obtained sufficiently. According to the technique described in JP-A 2003-65842 (KOKAI), a process for selectively forming silicide and a process for forming the pn junction become necessary besides the standard semiconductor process, resulting in a problem of an increased manufacturing cost.

SUMMARY OF THE INVENTION

The present invention has been made in view of these circumstances, and an object of thereof is to provide an infrared detector which efficiently absorbs infrared rays incident on cells and which can be manufactured at a low cost, and a solid-state image sensor having such an infrared detector.

An infrared detector according to a first aspect of the present invention, includes: a semiconductor substrate, a readout wiring portion provided on the semiconductor substrate, a support structure portion disposed over a concave portion which is formed in a surface part of the semiconductor substrate, the support structure portion having connection wiring connected electrically to the readout wiring portion, and a cell portion disposed over the concave portion and supported by the support structure portion. In addition, the cell portion includes an infrared absorption layer absorbing incident infrared rays, and a plurality of thermoelectric conversion elements connected electrically to the support structure portion and insulated electrically from the infrared absorption layer to generate an electric signal by detecting a temperature change of the cell portion. Furthermore, each of the thermoelectric conversion elements includes a semiconductor layer, a p-type silicon layer and an n-type silicon layer formed with a space between them in the semiconductor layer, and a polysilicon layer formed on the semiconductor layer between the p-type silicon layer and the n-type silicon layer. a solid-state image sensor according to a second aspect of the present invention, includes infrared detectors according to the first aspect arranged in a matrix form, and a readout circuit which conducts selection on detected signals respectively of the infrared detectors and reads out the detected signals successively.

BRIEF DESCRIPTION OF THE DRAWINGS

FIG. 1 is a sectional view of an infrared detector according to a first embodiment;
FIG. 2 is a plan view of the infrared detector according to the first embodiment;
FIG. 3 is a diagram showing characteristics of the infrared detector according to the first embodiment;
FIGS. 4 to 11 are sectional views showing a manufacturing process of the infrared detector according to the first embodiment;
FIG. 12 is a sectional view of an infrared detector according to a second embodiment;
FIG. 13 is a plan view of a thermoelectric conversion device in an infrared detector according to a third embodiment; and
FIG. 14 is a block diagram of a solid-state image sensor according to a fourth embodiment.

DESCRIPTION OF THE EMBODIMENTS

(First Embodiment)

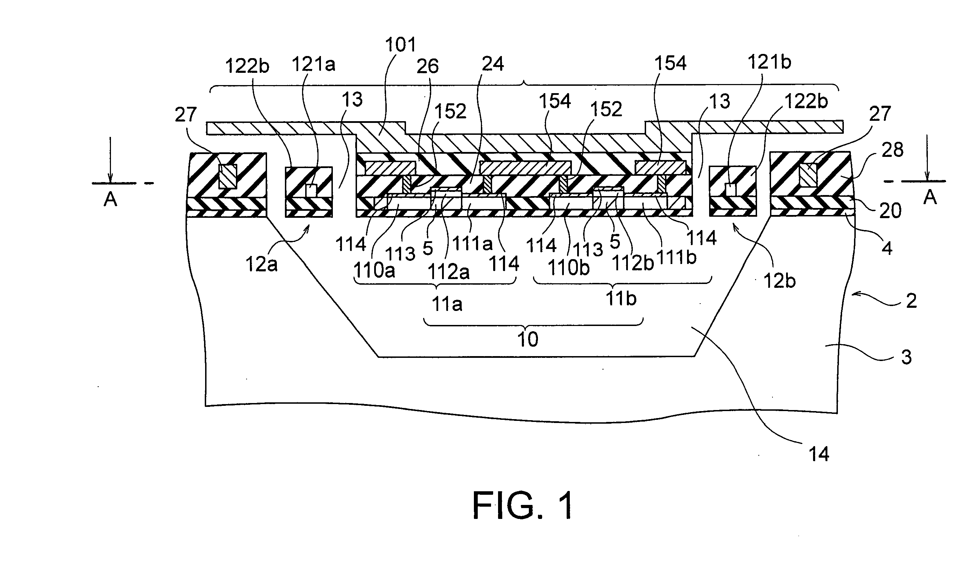

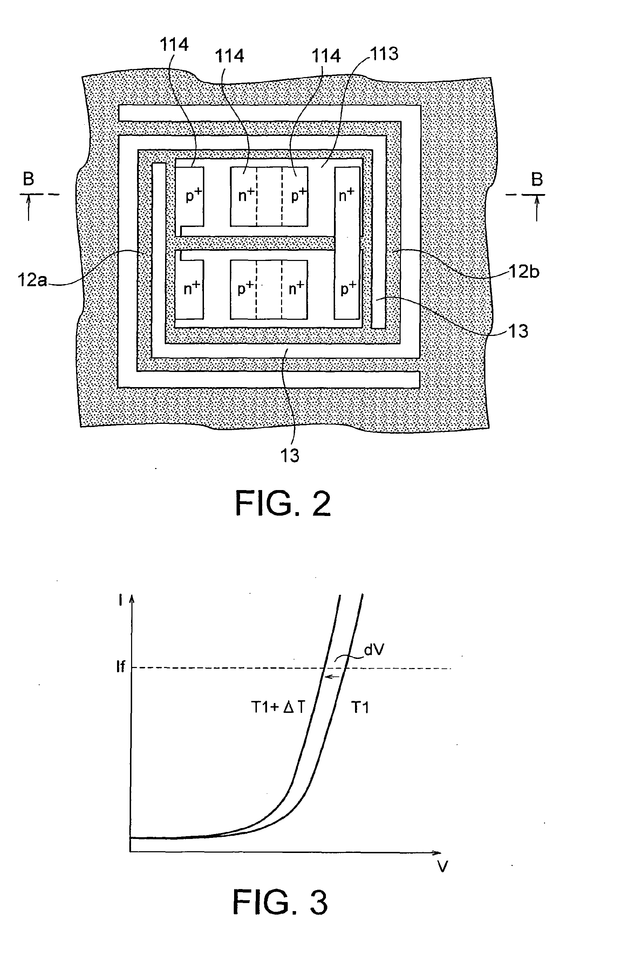

An infrared detector according to a first embodiment of the present invention is shown in FIGS. 1 and 2. FIG. 1 is a sectional view of the infrared detector according to the present embodiment. FIG. 2 is a plan view obtained by viewing a lower part from a cutting plane A-A shown in FIG. 1. FIG. 1 is a sectional view obtained by cutting along a cutting line B-B shown in FIG. 2.

An infrared detector 1 according to the present embodiment is formed in a SOI substrate 2 including a support substrate 3, a buried oxide film 4 and a SOI layer 5 formed of low concentration p-type silicon (hereafter referred to as p- type silicon). A plurality of thermoelectric conversion elements 11a and 11b, which will be described later, are formed in the SOI layer 5. The SOI layer except for the thermoelectric conversion elements 11a and 11b is replaced by an element isolation region 20 formed of, for example, silicon dioxide. A cavity portion (concave portion) 14 is provided on the buried oxide film 4 side of the support substrate 3. A cell portion 10 is provided over the buried oxide film 4 and the device isolation region 20 which are provided over the cavity portion 14. The cell portion 10 includes the thermoelectric conversion elements 11a and 11b, an insulation layer 24, a contact 152, wiring 154, an insulation layer 26 and an infrared absorption layer 101.

The thermoelectric conversion element 11a includes a p-type silicon layer 110a and an n-type silicon layer 111a formed with a space between them in the SOI layer 5 formed with p- type silicon, and a polysilicon layer 112a formed on the p- type silicon layer 5 between the p-type silicon layer 110a and the n-type silicon layer 111a. In the same way, the thermoelectric conversion element 11b includes a p-type silicon layer 110b and an n-type silicon layer 111b formed with a space between them in the SOI layer 5, and a polysilicon layer 112b formed on the p- type silicon layer 5 between the p-type silicon layer 110b and the n-type silicon layer 111b. Therefore, a pn junction in the thermoelectric conversion element 11a serves as a boundary between the p- type silicon layer 5 and the n-type silicon layer 111a, whereas a pn junction in the thermoelectric conversion element 11b serves as a boundary between the p-type silicon layer 5 and the n-type silicon layer 111b.

A silicide layer 114 is formed on a surface of each of the p-type silicon layer 110a, the n-type silicon layer 111a, the p-type silicon layer 110b and the n-type silicon layer 111b. A silicide layer 113 is formed on a surface of each of the polysilicon layer 112a and the polysilicon layer 112b. The silicide layer is connected to the wiring 154 via the contact 152. And in the present embodiment, the thermoelectric conversion elements 11a and 11b are connected in series via the contacts 152 and the wiring 154. In the present embodiment, four thermoelectric conversion elements are connected in series as appreciated from FIG. 2. The silicide layer 113 formed on the surface of each of the polysilicon layers 112a and 112b is not electrically connected to the silicide layer 114 formed on the surface of each of the p-type silicon layer 110a, the n-type silicon layer 111a, the p-type silicon layer 110b and the n-type silicon layer 111b. These silicide layers 113 and 114 function as a reflection layer which reflects incident infrared rays to cause the infrared rays to be absorbed in the infrared absorption layer 101 which will be described later.

The insulation layer 24 is provided so as to cover the thermoelectric conversion elements 11a and 11b and the element isolation region 20. The contacts 152 electrically connected to the thermoelectric conversion elements 11a and 11b are provided in the insulation layer 24. The wiring 154 connected to the contacts 152 is formed on the insulation layer 24. The insulation layer 26 is formed so as to cover the wiring 154 and the insulation layer 24. The infrared absorption layer 101 is provided on the insulation layer 26. The infrared absorption layer 101 extends to a region (a region where a peripheral circuit is formed) of the SOI substrate located outside the cavity portion 14.

The cell portion 10 is supported by a support structure portion provided on the cavity portion 14 around the cell portion 10. The support structure portion includes a first support portion 12a and a second support portion 12b disposed around the cell portion 10 so as not to intersect each other. Openings 13 communicating to the cavity portion 14 are provided between the cell portion 10 and the first support portion 12a and between the cell portion 10 and the first support portion 12b. The first and second support portions 12a and 12b includes connection wiring 121a and 121b provided on the element isolation region 20, and protection films 122a and 122b which cover the wiring 121a and 121b, respectively. First ends of the first and second support portions 12a and 12b are coupled to the insulation film 24, and second ends of the first and second support portions 12a and 12b are coupled to the a protection film 28 which will be described later. First ends of the connection wiring 121a and 121b respectively in the first and second support portions 12a and 12b are electrically connected to the wiring 154 via contacts which are provided in the insulation film 24 and which are not illustrated, and second ends of the connection wiring 121a and 121b are electrically connected to readout wiring 27 which will be described later. Therefore, the first ends of the connection wiring 121a and 121b are electrically connected to the thermoelectric conversion elements 11a and 11b via the contact, the wiring 154 and the contact 152. The protection film 28 is provided on the element isolation region 20 excluding the region in which the cavity portion 14 is formed. The readout wiring 27 is formed in the protection film 28.

The infrared detector according to the present embodiment absorbs long wavelength light incident on the infrared absorption layer 101, and raises the temperature of itself by generated thermal energy Pa. Since the infrared detector according to the present embodiment is made to operate in the vacuum, the escape path of heat from the cell portion 10 becomes only the support structure portion formed of the first and second support portions 12a and 12b. Therefore, the adiabatic property of the cell portion 10 depends upon the thermal conductance of the support structure portion. As the length of the support structure portion is lengthened and the support structure portion is made thin, the adiabatic property is improved.

Letting the thermal conductance of the whole support structure portion be $G_{th}$, the temperature of the cell portion 10 is raised according to the following equation by the generated thermal energy.

$$\Delta T = \frac{P_a}{G_{th}} \left\{ 1 - \exp(-t G_{th} / C_{th}) \right\} \qquad (1)$$

Here, t is elapsed time since the start of light incidence, and $C_{th}$ is a thermal capacity of the cell portion 10. The temperature of the cell portion 10 reaches a steady state with a thermal time constant $\tau$ expressed by equation (2).

$$\tau = C_{th} / G_{th} \qquad (2)$$

The thermal time constant given by the equation (2) becomes a response speed in the heat-type infrared detector.

When the cell portion 10 takes the shape of a square having a size of approximately 30 $\mu$m by 30 $\mu$m and has a height in the range of approximately 4 to 5 $\mu$m, the support structure portion includes first and second support portions, the square section size of the protection films 122a and 122b in the support structure portion is approximately 1 $\mu$m, and the length of the support structure portion (i.e., the length from the cell portion 10 to the protection film 28 for the readout wiring 27) is approximately 70 $\mu$m, the above-described thermal time constant is in the range of approximately 20 to 50 msec.

A temperature rise $\Delta T_{IR}$ of the cell portion 10 caused by receiving infrared rays is given by the following equation.

$$\Delta T_{IR} = \frac{P_a}{G_{th}} \qquad (3)$$

The temperature rise $\Delta T_{IR}$ of the cell portion 10 is detected by the thermoelectric conversion elements 11a and 11b formed in a lower layer of the cell portion 10.

In the present embodiment, pn junction diodes are used in the thermoelectric conversion elements 11a and 11b. The fact that the total quantity of the resistance change caused by a temperature rise is increased by connecting a plurality of diodes in series is utilized. As the number of connected diodes becomes large, the sensitivity becomes high.

For outputting a signal voltage generated by the diodes, a method of letting a constant current flow through the thermoelectric conversion elements 11a and 11b connected in series via the readout wiring 27 and the connection wiring 121a and 121b and detecting a change of a voltage between ends in that state is convenient.

In this drive method, the thermoelectric conversion rate is represented by dV/dT, and a voltage change dV is generated by a temperature rise $\Delta T$ of the cell portion 10. In the steady state, therefore, a voltage signal represented by the following equation is output from the cell portion 10.

$$dV = \Delta T \cdot \frac{dV}{dT} = \frac{P_a}{G_{th}} \frac{dV}{dT} \qquad\qquad (4)$$

Characteristics of this voltage change are shown in FIG. 3.

The configurations of the thermoelectric conversion elements 11a and 11b according to the present embodiment can be formed by using the gate forming process and the source-drain forming process for ordinary transistors. A plane profile of the pn junctions can be determined in a self-aligned manner by patterns of the polysilicon layers 112a and 112b. Hereafter, a method for manufacturing the infrared detector according to the present embodiment will be described.

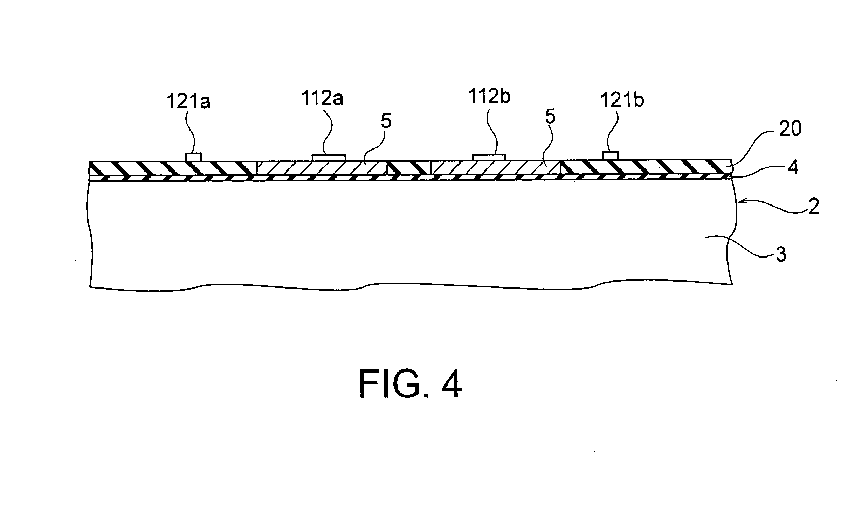

Manufacturing processes for the infrared detector according to the present embodiment are shown in FIGS. 4 to 11.

First, the element isolation region 20 is formed in the SOI layer 5 of the SOI substrate 2, and pn junctions are formed on the remaining SOI layer 5, as shown in FIG. 4. Here, the SOI substrate 2 has a laminated structure of the SOI layer 5, the buried oxide film 4 and the support substrate 3. Subsequently, polysilicon is deposited and patterned to form the polysilicon layers 112a and 112b and the connection wiring 121a and 121b.

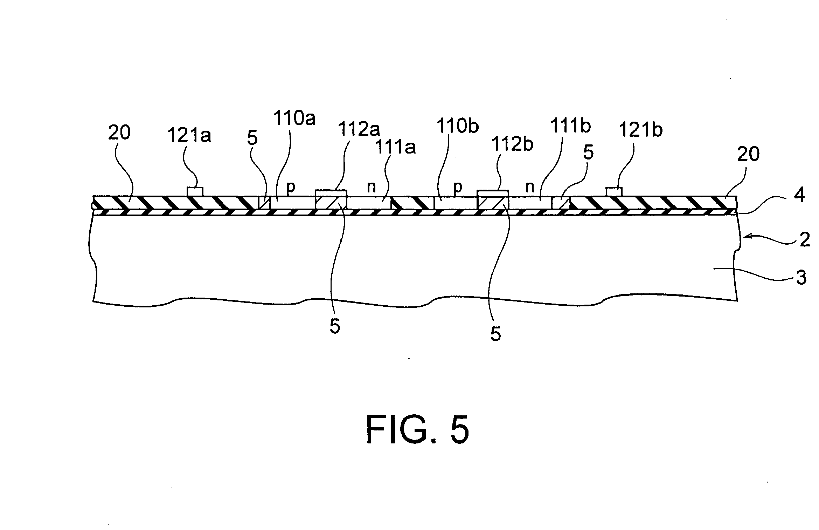

Subsequently, ion implantation of p-type impurities and n-type impurities is conducted on the SOI layer 5 as shown in FIG. 5. Ion implantation is conducted by using the polysilicon layers 112a and 112b as a mask. For example, as for the polysilicon side of the p-type silicon layer 110a shown in FIG. 5, the polysilicon layer 112a is used as a mask. As for the opposite side, a photomask is used for defining. As a result, a space between the p-type silicon layer 110a and the n-type silicon layer 111a is determined by the size of the polysilicon layer 112a in a self-aligned manner. In addition, a space between the p-type silicon layer 110b and the n-type silicon layer 111b is determined by the size of the polysilicon layer 112b in a self-aligned manner. As a result, manufacturing dispersion can be completely eliminated.

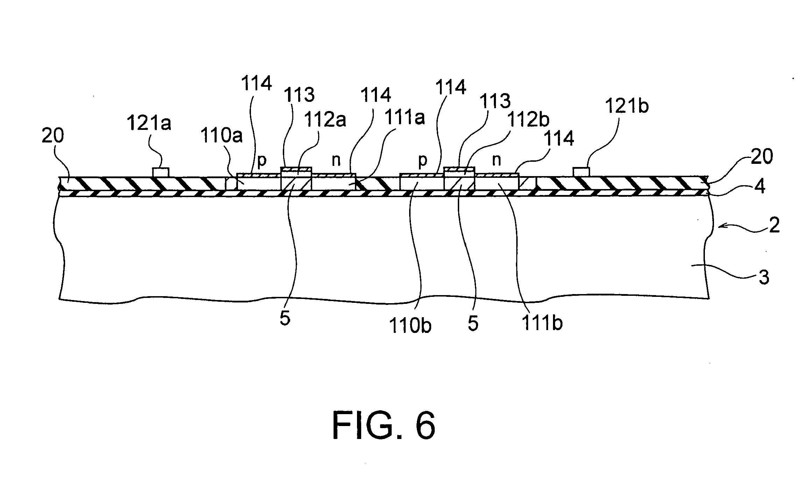

Subsequently, side walls are formed for the polysilicon layer in the same way as ordinary transistors (not illustrated). The silicide layer 113 is formed on the surface of each of the polysilicon layers 112a and 112b. In addition, the silicide layer 114 is formed on the surface of each of the p-type silicon layers 110a and 110b and the n-type silicon layers 111a and 111b (FIG. 6). The silicide layer is formed by, for example, forming a thin Ti film on silicon, and conducting anneal processing to alloy silicon with Ti. As a result, the resistance of the silicon surface can be made low.

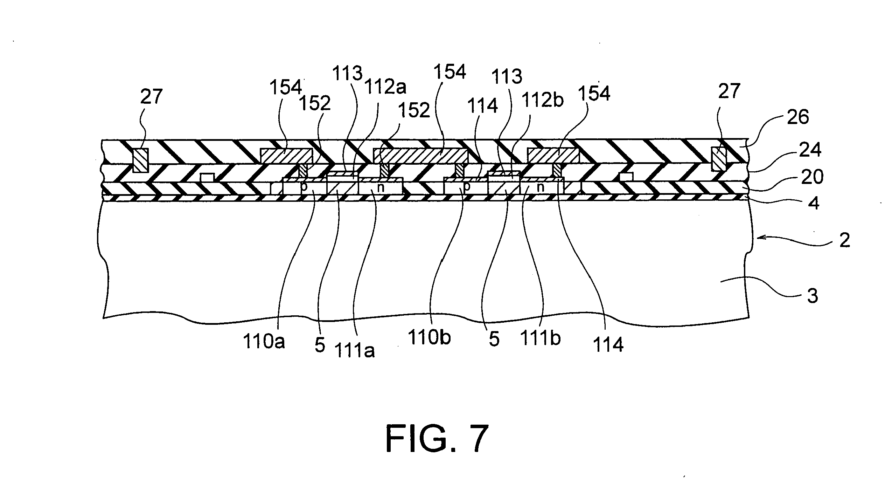

Subsequently, the contacts 152, the wiring 154 and 27 are formed as shown in FIG. 7. First, the insulation film 24 of $SiO_2$ or the like is formed, and contact holes are formed through the insulation film 24. A metal material such as tungsten is buried into the contact holes to form the contacts 152. In addition, a wiring material film is formed of aluminum or the like. This wiring material film is patterned to form the wiring 154 and 27. Finally, the wiring 154 and 27 is buried with the insulation film 26. As a result, sectional shapes shown in FIG. 7 are obtained.

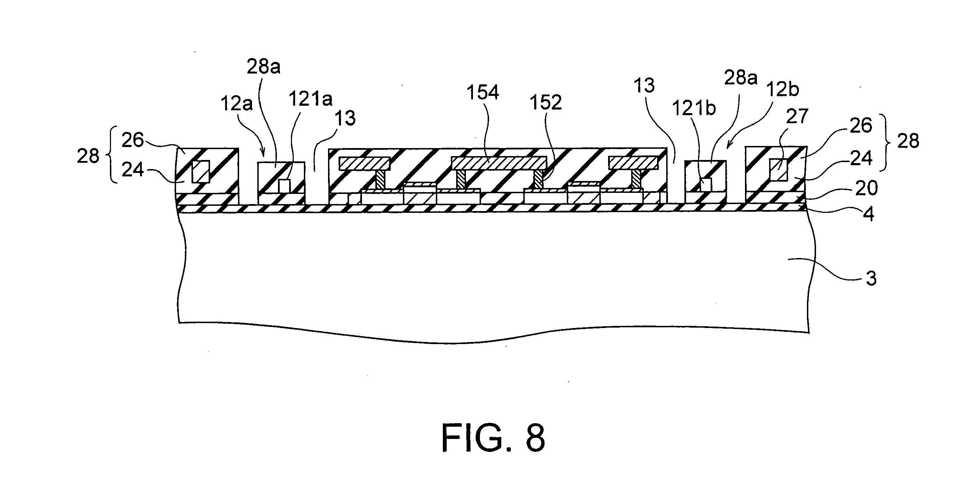

Subsequently, the openings 13 are formed by using the RIE (Reactive Ion Etching) as shown in FIG. 8. Plane shapes of the first and second support portions 12a and 12b are determined by the openings 13. Subsequently, RIE is conducted on the insulation film 28 which is upper portions of the first and second support portions 12a and 12b to make an insulation film 28a thin. As a result, the section area of the first and second support portions 12a and 12b in a direction perpendicular to the surface of the support substrate 3 is reduced. Accordingly, the final adiabatic property is improved.

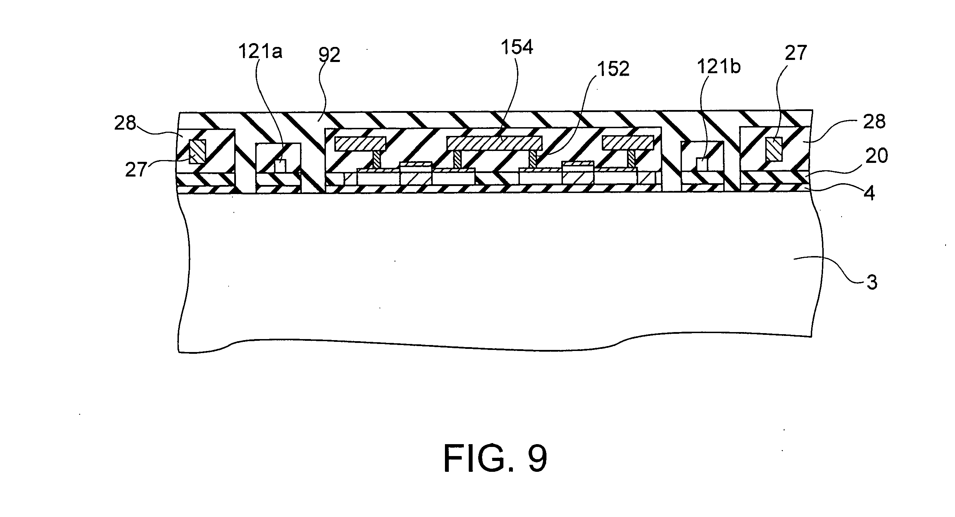

Subsequently, the infrared absorption layer 101 is formed. As appreciated from FIG. 1, the infrared absorption layer 101 takes the shape of projecting over the first and second support portions 12a and 12b and the wiring 27. Therefore, it is necessary to form a foundation. As shown in FIG. 9, therefore, a sacrifice layer 92 is formed on the whole surface to bury the openings 13. The sacrifice layer 92 may be formed of a material having a good etching selection ratio with respect to the insulation film ($SiO_2$ or the like) which forms the outer face of the cell, such as, for example, amorphous silicon or polysilicon.

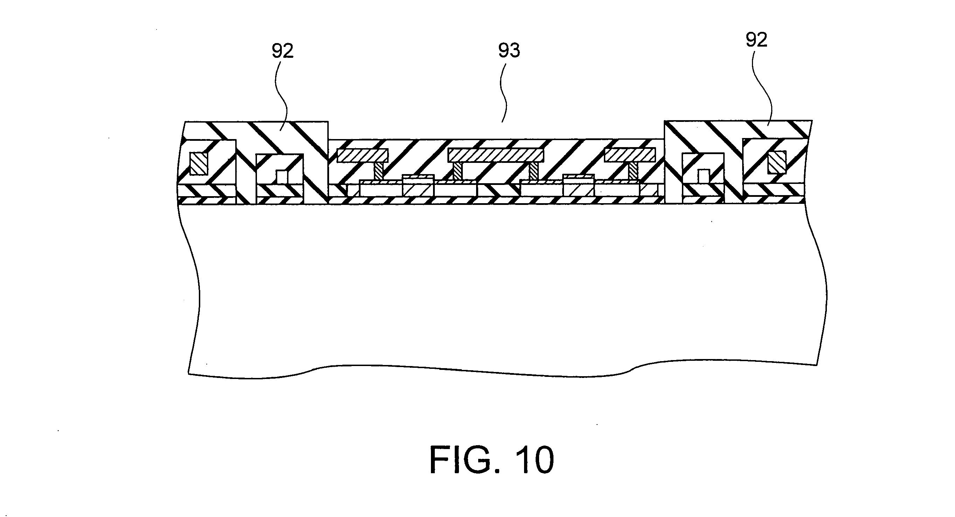

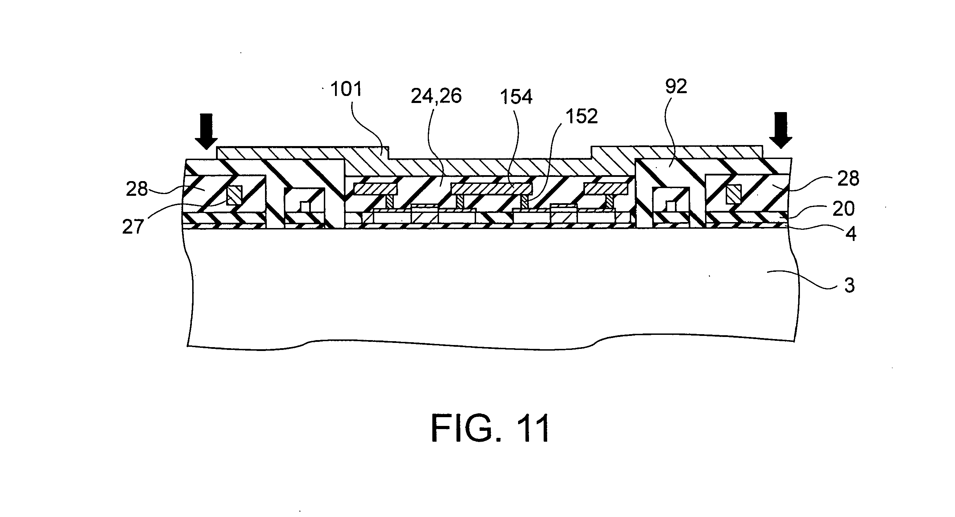

Subsequently, a contact hole 93 is formed in the sacrifice layer 92 by using the RIE as shown in FIG. 10, and the infrared absorption layer 101 is formed as shown in FIG. 11. In this state, the infrared absorption layer 101 is connected to the upper face of the cell portion 10. Since the infrared absorption layer 101 is coupled to adjacent cells, however, etching is conducted in places indicated by arrows in FIG. 11 to separate cells and the sacrifice layer 92 is exposed. Thereafter, the sacrifice layer 92 and the support substrate 3 located right under the cell portion 10 are etched by using an etching solution such as, for example, TMAH. Thus, the section structure shown in FIG. 1 is completed, and the infrared detector according to the present embodiment is formed.

As appreciated from the foregoing description, the infrared detector according to the present embodiment can be manufactured at a low cost without adding a process for forming pn junctions to the ordinary CMOS process. Furthermore, since the influence of mask misalignment can be avoided by self-aligned ion implantation using dummy polysilicon, the manufacture yield is improved remarkably.

In the present embodiment, the infrared absorption layer 101 covers the cell portion 10. Therefore, more infrared rays incident on the cell portion can be absorbed. Furthermore, since it becomes possible to lengthen the length of the first and second support portions which support the cell portion 10 as far as possible and reduce the section area, the adiabatic property is improved and the heat of absorbed infrared rays can be prevented from being scattered and lost as far as possible, and consequently it becomes possible to absorb the absorbed infrared rays efficiently.

(Second Embodiment)

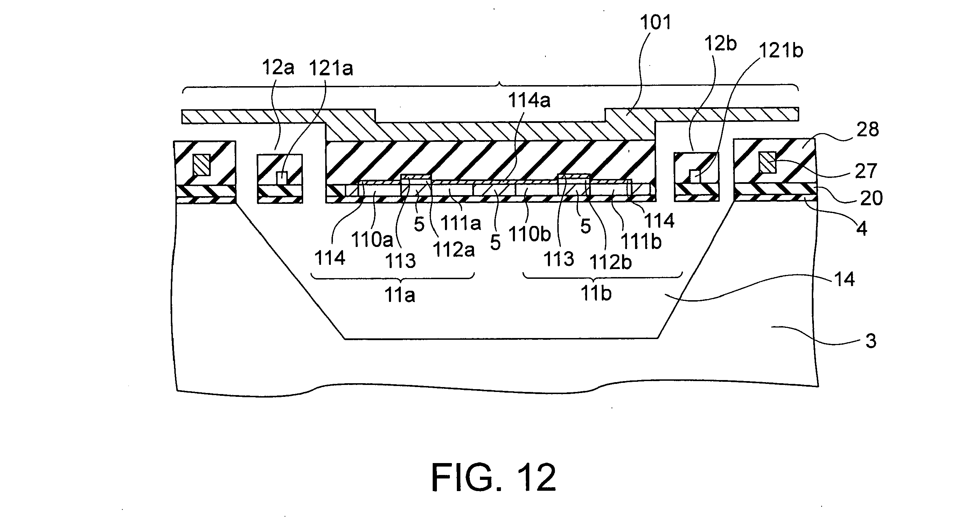

An infrared detector according to a second embodiment of the present invention is shown in FIG. 12. The infrared detector 1 according to the present embodiment is obtained from the infrared detector according to the first embodiment shown in FIG. 1 by forming the SOI layer 5 instead of the element isolation region 20 between the thermoelectric conversion elements 11a and 11b and forming a silicide layer 114a on surfaces of the SOI layer 5, the n-type silicon layer 111a and the p-type silicon layer 110b. Thus, the infrared detector 1 according to the present embodiment has a configuration in which the thermoelectric conversion elements 11a and 11b are connected in series. Therefore, the wiring 154 and the contacts 152 become unnecessary. As a result, the thermal capacity of the cell portion 10 can be reduced remarkably, and the thermal time constant $\tau$ can be made small. Accordingly, the thermal response of the cell portion 10 can be quickened.

(Third Embodiment)

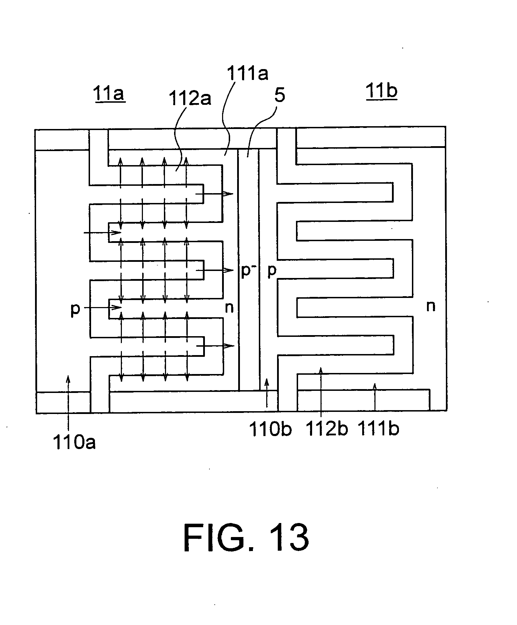

An infrared detector according to a third embodiment of the present invention will now be described with reference to FIG. 13. FIG. 13 is a top view of the thermoelectric conversion elements 11a and 11b in the infrared detector according to the present embodiment.

The infrared detector according to the present embodiment is obtained from the infrared detector according to the first or second embodiment by forming the polysilicon layers 112a and 112b, respectively formed on regions between the p-type silicon layers 110a and 110b and the n-type silicon layers 111a and 111b respectively in the thermoelectric conversion elements 11a and 11b, in a winding form and providing the p-type silicon layers 110a and 110b and the n-type silicon layers 111a and 111b, which are isolated respectively by the polysilicon layers 112a and 112b, with comb teeth shapes.

As compared with the layout of the infrared detector according to the first or second embodiment, the area of the pn junction can be increased and the forward current which flows through the pn junction can be increased by adopting such a structure. If semiconductor layers right under the polysilicon layers 112a and 112b are p-type (low concentration p⁻), the pn junction becomes the n-type silicon layer 111a and 111b side. The area of the pn junction is a product of a length of winding where the n-type silicon layers 111a and 111b are respectively in contact with the polysilicon layers 112a and 112b and an impurity diffusion depth of the n-type silicon layers 111a and 111b. The area of the junction becomes large as the length of the winding becomes long and as the depth of the diffusion layer of the n-type silicon layer becomes deep. As a result, the forward current obtained when the same forward voltage is applied becomes large.

The forward current $I_f$ of a diode is represented by the following equation.

$$I_f = A \cdot I_s \cdot \{\exp(qV_f/kT) - 1\} \qquad (5)$$

Here, $V_f$ is the forward voltage, A is the area of the pn junction, $I_s$ is the saturation current which does not depend upon $V_f$, q is the elementary charge, k is the Boltzman constant, and T is the absolute temperature. As appreciated from the equation (5), $I_f$ is in proportion to A. For increasing $I_f$, therefore, it is important to expand the area of the junction.

The fact that high $I_f$ is obtained for a certain value of $V_f$ means conversely that $V_f$ required to let flow a certain constant current falls. Especially if a large number of pn junctions are connected in series, the drive voltage is lowered. If $V_f$ falls, then the thermoelectric conversion efficiency represented by the following equation (6) is improved.

$$\frac{dV}{dT} = \frac{1.21 - V_f}{T} \qquad (6)$$

The infrared detector according to the present embodiment can be fabricated by changing the plane photomask layout of the polysilicon layers 112a and 112b, the p-type silicon layers 110a and 110b, and the n-type silicon layers 111a and 111b and executing processes similar to those of the first embodiment.

By the way, in the first to third embodiments, the SOI layer 5 is a p-type silicon layer which is lower in concentration than the p-type silicon layers 110a and 110b. Alternatively the SOI layer 5 is an n-type silicon layer which is lower in concentration than the n-type silicon layers 111a and 111b. In this case, the pn junction is formed between the low concentration n-type silicon layer and the p-type silicon layers 110a and 110b.

(Fourth Embodiment)

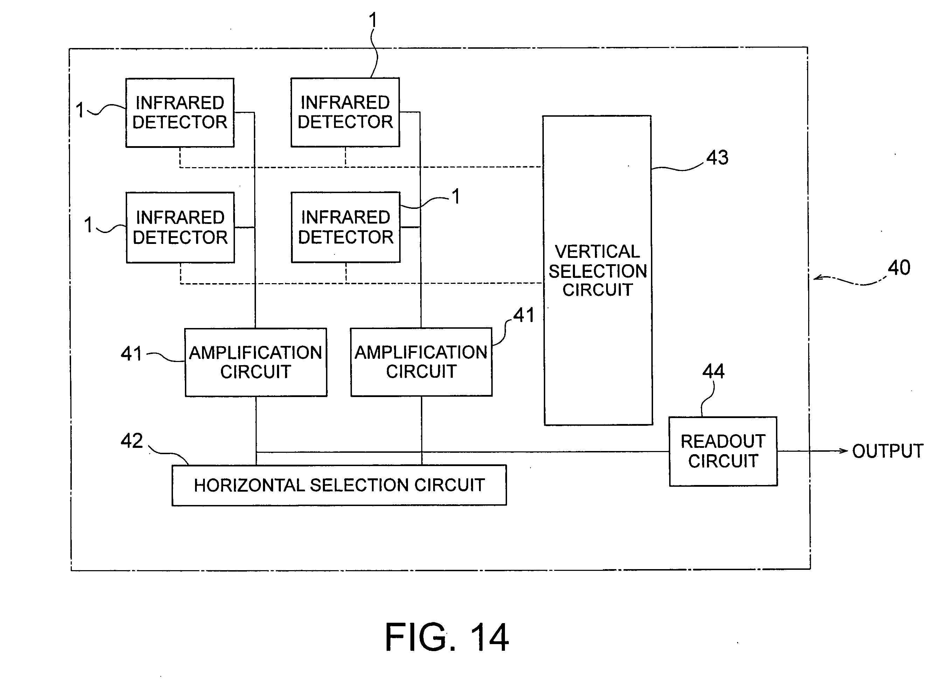

A block diagram of a solid-state image sensor according to a fourth embodiment of the present invention is shown in FIG. 14. The solid-state image sensor according to the present embodiment is constituted by using an infrared detector according to any one of the first to third embodiments.

A solid-state image sensor 40 according to the present embodiment includes infrared detectors 1 according to one of the first to third embodiments arranged in a matrix form, a vertical selection circuit 43 which conducts selection on the infrared detectors by taking a row as the unit, a plurality of amplification circuits 41 provided respectively for columns of the infrared detectors 1, and a horizontal selection circuit 42 which selects outputs of the amplification circuits 41 in order.

The vertical selection circuit 43 in the solid-state image sensor 40 selects output signals of the infrared detectors with a row as the unit. The horizontal selection circuit 42 selects an output signal successively from the output signals of the infrared detectors 1 on a specific row selected by the vertical selection circuit 43. The output signal thus selected is sent to a readout circuit 44. The readout circuit 44 conducts noise subtraction processing and integration processing, then conducts A/D conversion and signal processing, and outputs a resultant signal to external.

According to the solid-state image sensor the solid-state image sensor according to the fourth embodiment thus configured, it is possible to absorb infrared rays incident on cells efficiently and manufacture the solid-state image sensor at a low cost because the infrared detectors 1 according to one of the first to third embodiments are arranged in a matrix form.

Additional advantages and modifications will readily occur to those skilled in the art. Therefore, the invention in its broader aspects is not limited to the specific details and representative embodiments shown and described herein. Accordingly, various modifications may be made without departing from the spirit or scope of the general inventive concepts as defined by the appended claims and their equivalents.

**Claims**

1. An infrared detector comprising:

   a semiconductor substrate;
   a readout wiring portion provided on the semiconductor substrate;
   a support structure portion disposed over a concave portion which is formed in a surface portion of the semiconductor substrate, the support structure portion having connection wiring connected electrically to the readout wiring portion; and
   a cell portion disposed over the concave portion and supported by the support structure portion,
   wherein
   the cell portion comprises:

      an infrared absorption layer absorbing incident infrared rays; and
      a plurality of thermoelectric conversion elements connected electrically to the support structure portion and insulated electrically from the infrared absorption layer to generate an electric signal by detecting a temperature change of the cell portion,
      each of the thermoelectric conversion elements comprises a semiconductor layer, a p-type silicon layer and an n-type silicon layer formed with a space between them in the semiconductor layer, and a polysilicon layer formed on the semiconductor layer between the p-type silicon layer and the n-type silicon layer.

2. The detector according to claim 1, wherein metal silicide is formed on surface(s) of some or all of the polysilicon layer, the p-type silicon layer and the n-type silicon layer.

3. The detector according to claim 2, wherein the metal silicide serves also as wiring for connecting the thermoelectric conversion elements in series.

4. The detector according to claim 1, wherein the semiconductor layer is a p-type silicon layer or an n-type silicon layer which is lower in concentration than the p-type silicon layer or the n-type silicon layer.

5. The detector according to claim 1, wherein the thermoelectric conversion elements are isolated from each other by an insulation film.

6. The detector according to claim 1, wherein
the semiconductor layer is present between the thermoelectric conversion elements,
a silicide layer is formed on the semiconductor layer, and
the thermoelectric conversion elements are connected in series by the silicide layer.

7. A solid-state image sensor comprising:

   infrared detectors according to claim 1 arranged in a matrix form; and
   a readout circuit which conducts selection on detected signals respectively of the infrared detectors and reads out the detected signals successively.

8. The sensor according to claim 7, wherein metal silicide is formed on surface(s) of some or all of the polysilicon layer, the p-type silicon layer and the n-type silicon layer.

9. The sensor according to claim 8, wherein the metal silicide serves also as wiring for connecting the thermoelectric conversion elements in series.

10. The sensor according to claim 7, wherein the semiconductor layer is a p-type silicon layer or an n-type silicon layer which is lower in concentration than the p-type silicon layer or the n-type silicon layer.

11. The sensor according to claim 7, wherein the thermoelectric conversion elements are isolated from each other by an insulation film.

12. The sensor according to claim 7, wherein
the semiconductor layer is present between the thermoelectric conversion elements,
a silicide layer is formed on the semiconductor layer, and
the thermoelectric conversion elements are connected in series by the silicide layer.

FIG. 1

FIG. 2

FIG. 3

FIG. 4

FIG. 5

## FIG. 6

FIG. 7

FIG. 8

EP 2 105 963 A2

FIG. 9

EP 2 105 963 A2

FIG. 10

EP 2 105 963 A2

FIG. 11

FIG. 12

FIG. 13

40

43 — VERTICAL SELECTION CIRCUIT

44 — READOUT CIRCUIT → OUTPUT

1 — INFRARED DETECTOR

1 — INFRARED DETECTOR

1 — INFRARED DETECTOR

1 — INFRARED DETECTOR

41 — AMPLIFICATION CIRCUIT

41 — AMPLIFICATION CIRCUIT

42 — HORIZONTAL SELECTION CIRCUIT

FIG. 14

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003065842 A